# EUROPEAN PATENT SPECIFICATION

(11) **EP 1 735 844 B1**
(45) Date of publication and mention of the grant of the patent: **19.06.2019**
(21) Application number: 05728618.9
(22) Date of filing: 18.03.2005
(51) Int. Cl.: H01L 25/075, H01L 33/60, H01L 33/62

(54) **USE OF A HIGH-DENSITY LIGHT EMITTING DIODE ARRAY COMPRISING MICRO-REFLECTORS FOR CURING APPLICATIONS**
VERWENDUNG EINES HOCHDICHTEN LEUCHTDIODEN-ARRAYS MIT MIKRO-REFLEKTOREN FÜR AUSHÄRTUNGSVERFAHREN
UTILISATION D'UN RÉSEAU DE DIODES ÉLECTROLUMINESCENTES À HAUTE DENSITÉ COMPRENANT DES MICRO-RÉFLECTEURS POUR DES PROCÉDÉS DE DURCISSEMENT

(30) Priority: 18.03.2004 US 554628 P
(43) Date of publication of application: 27.12.2006
(73) Proprietor: Phoseon Technology, Inc., Hillsboro, Oregon 97124 (US)
(72) Inventor: OWEN, Mark, D., Beaverton, OR 97006 (US); ANDERSON, Duwayne, R., St. Helens, OR 97051 (US); MCNEIL, Thomas, R., Portland, OR 97229 (US); SCHREINER, Alexander, F., Hillsboro, OR 97124 (US)
(74) Representative: Herrmann, Uwe
(86) International application number: PCT/US2005/009407
(87) International publication number: WO 2005/091392

(56) References cited:
- EP-A1- 0 377 352
- EP-A2- 0 921 568
- EP-A2- 1 260 196
- WO-A1-03/030274
- WO-A2-02/15281
- DE-U1- 20 116 022
- GB-A- 2 139 340
- JP-A- 58 199 576
- JP-A- 2004 079 750
- US-A- 4 797 715
- US-A- 4 935 665
- US-A- 5 003 357
- US-A- 5 119 174
- US-A- 5 418 384
- US-A1- 2001 046 652
- US-A1- 2004 184 270
- US-B1- 6 225 139
- US-B2- 6 578 989

## Description

### Background of the Invention

This invention relates to high-density light emitting diode (LED) arrays and, more particularly, to a lower cost LED array that has improved collection and collimation of light.

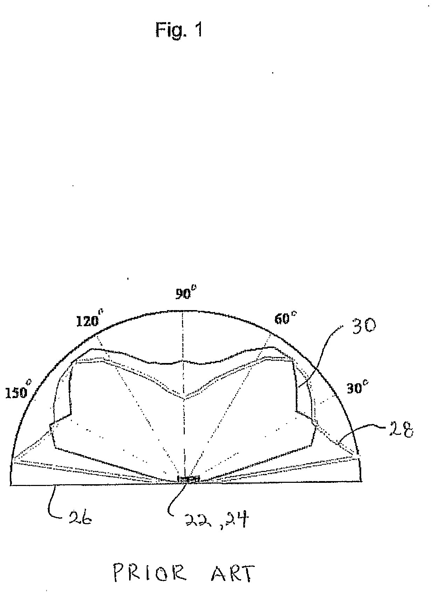

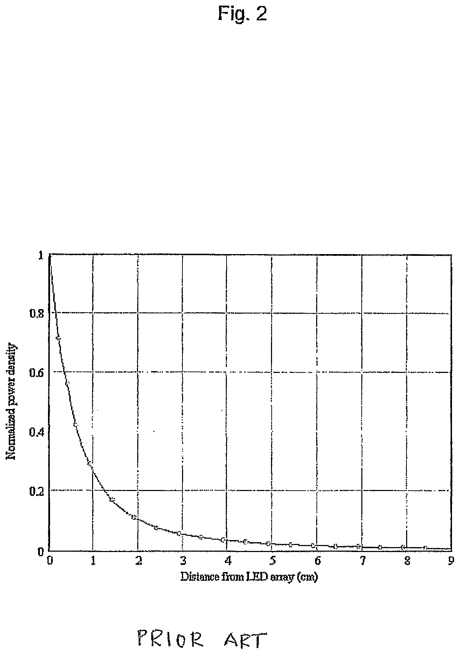

High-density UV LED arrays may be used for curing applications ranging from ink printing to the fabrication of DVDs and lithography. Many such applications require a high optical power density at the working surface. However, light distribution from a typical LED is highly divergent. For example, Fig. 1 is a graphic illustration showing radiation distribution for two different LEDs 22, 24 mounted on a surface 26 without refractive or reflective optics. Ideally, for such applications, the light from an LED would be distributed substantially 90 degrees from substrate 26. However, typical LEDs emit highly divergent light. Curve 28 is a representative example of radiation distribution from first LED 22 and curve 30 is a representative example of radiation distribution from second LED 24. As can be seen, much of the optical radiation from the LEDs 22, 24 is emitted at highly oblique angles. This causes the optical power density to fall off quickly as a function of the distance of the work surface from the LED, which is graphically illustrated in Fig. 2 for an LED array without refractive or reflective optics. The illustrations of Figs. 1 and 2 would be different for different LEDs and different arrays and would depend on the number and spacing of LEDs in the array. To achieve the required optical power density the LED array must often be located physically closer to the work surface than is desired necessitating mechanical changes to tooling and/or shielding to accommodate its near proximity. However, locating the LED array too far from the work surface may diminish the optical power density to undesired levels.

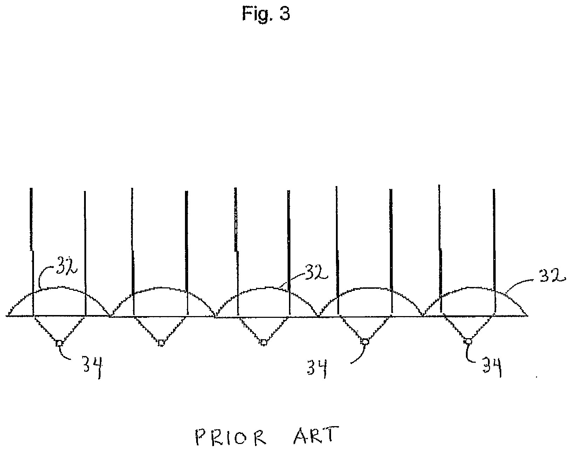

There are known methods of achieving higher optical power density. For example, some LEDs are used with Lambertian optical outputs to achieve a higher optical power density. However, such devices are less efficient in electrical to optical conversions as well as being less thermally efficient. Another method of achieving higher optical power density is shown if Fig. 3 in which an array of refractive optical elements 32 is located above an array of LEDs 34 in which each LED 34 is associated with an optical element 32. Each optical element 32 collects and collimates the light from its associated LED 34. However, this method is inefficient because light from LEDs is highly divergent causing much of the light to fall outside the numerical aperture of the lenses. The numerical aperture of a lens is defined as the sine of the angle between the marginal ray (the ray that exits the lens system at its outer edge) and the optical axis multiplied by the index of refraction (n) of the material in which the lens focuses. In order to more effectively collect and collimate the light the optical component must have a very high numerical aperture resulting in a lens that has a very large diameter and a very short focal length. In practice, it is not possible to manufacture a refractive optical element that collects all of the light from an LED because that would require the angle between the optical axis and the marginal ray to be 90 degrees, implying a lens of either a zero focal length or an infinite diameter.

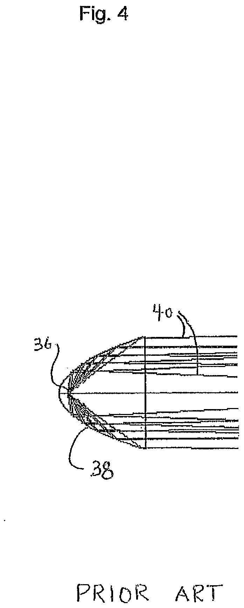

Another common approach to collecting and collimating light from an LED is to use a parabolic reflector as shown in Fig. 4. An LED 36 is mounted in parabolic reflector 38 so that light rays 40 emitted from LED 36 are collected and collimated. For example, a typical application of such refractive optics is with LED-mounted flashlights in which the refractive optic collimates light from only a single LED. Unlike reflective optics, reflective optics can easily collect all the light from the LED even at very highly oblique angles. However, known reflective optics are not capable of being used in a tightly packed or dense array because of their size. Furthermore, macro-reflectors that are larger than an optical array are not as optically efficient as the micro-reflectors of this invention.

Additionally, in known optical devices the reflector is separate from the electrical circuitry of the device. For example, such devices typically utilize a macro-reflector for an entire array of LEDs. The optical efficiency of these devices is lowered because each LED does not have an associated reflector. Furthermore, the separate reflector increases the cost of manufacturing. Additionally, the volume of space required for the macro-reflector is very large making it less useful for some applications.

US 5119174, US 6225139, EP 0921568, WO 02/15281 and WO 03/030274 disclose a high-density light emitting diode array module. EP 1260196 and US 2001/0046652 disclose the use of a high-density light emitting diode array module for curing in dental applications.

### Summary of the Invention

The present invention provides the use of a low-cost LED array module for curing applications in ink printing, DVD fabrication or lithography according to claim 1, to better collect and collimate light from the LED array. The improved collection and collimation of the LED light allows the LED array to be physically located further away from a work surface yet maintain high optical power during its use.

The present invention provides the use of a very dense LED array in which individual LEDs are mounted on a substrate formed with an array of openings that function as micro-reflectors.

Preferably, the substrate is of a material that is electrically insulating and thermally conductive. The micro-reflectors are formed in a truncated pyramidal shape. The substrate may be anisotropically etched to form the micro-reflectors having a truncated pyramidal shape. Preferably, the substrate is a crystalline silicon having defined crystallographic axes along which the substrate is etched to form openings in the substrate having walls with a characteristic slope. The openings are then metallized and structured to define separate circuits. The resulting substrate has openings formed in a dense array, which openings are then coated with a reflective and electrically conductive material so that the openings function both as electrical connections and as micro-reflectors. The substrate is then assembled LEDs mounted within each micro-reflector and wired into a circuit on the substrate. The array is then electrically connected to a power source. The substrate may be formed of any size but the micro-reflectors are arranged in a dense array having a center-to-center spacing of 3 mm or less.

In another example, not forming part of the present invention, a very dense LED array is provided in which an array of parabolic micro-reflectors is formed in a substrate of silicon or other thermally conductive semiconductor and ceramic materials such as diamond, SiC, AlN, BeO, Al2O3, or combinations of these with other materials. The parabolic micro-reflectors can be laser and/or plasma machined into the substrate.

The present invention provides the use of an LED array module that includes a plurality of LEDs mounted on a thennal substrate formed with a plurality of truncated pyramidally shaped openings that function as micro-reflectors, wherein each LED is associated with a micro-reflector, each micro-reflector including a layer of reflective and conductive material to reflect light from its associated LED and to electrically power its associated LED.

These and other embodiments are described in more detail in the following detailed description in conjunction with the drawings.

### Brief Description of the Drawings

Figure 1 shows radiation distribution for two LEDs without refractive or reflective optics.
Figure 2 shows a graph of an example of power drop-off as a function of distance from the LED array for a specific array.
Figure 3 shows an example of prior art refractive lenses used to collect and collimate light from an array of LEDs.
Figure 4 shows a common approach of collecting and collimating light from an LED with a parabolic reflector.
Figure 5 is an enlarged top view of a portion of an LED array.
Figure 6 is a view of the LED array of Figure 5 taken along line 6-6.
Figure 7 is a top view of the substrate formed with an array of pockets.
Figure 8 is an enlarged partial top view of a portion of the substrate of Figure 7.
Figure 9 is an enlarged partial side view of a portion of the substrate of Figure 7.
Figure 10 is a graphic illustration showing the improved directionality of light from an LED with reflective pockets of the substrate.
Figure 11 is a graph of calculated power as a function of distance for an LED array arranged on a grid with 1 mm center-to-center spacing.
Figure 12 is an LED array module with parabolic micro-reflectors.
Figure 13 is an LED array module in which the micro-reflectors are formed by a combination of etching and machining.
Figure 14 is an LED array module incorporating an array of micro-lenses.

### Detailed Description of the Invention

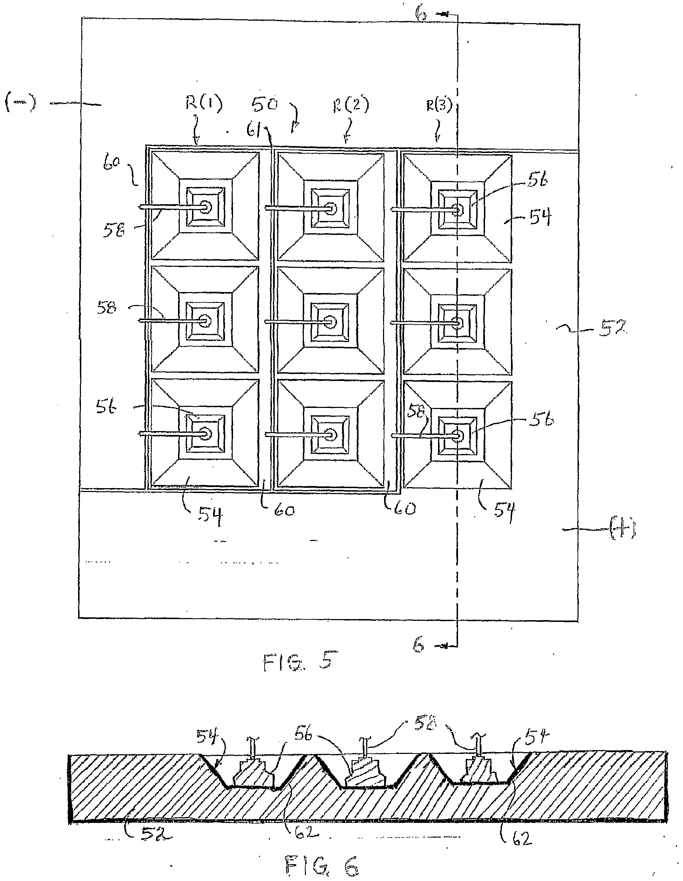

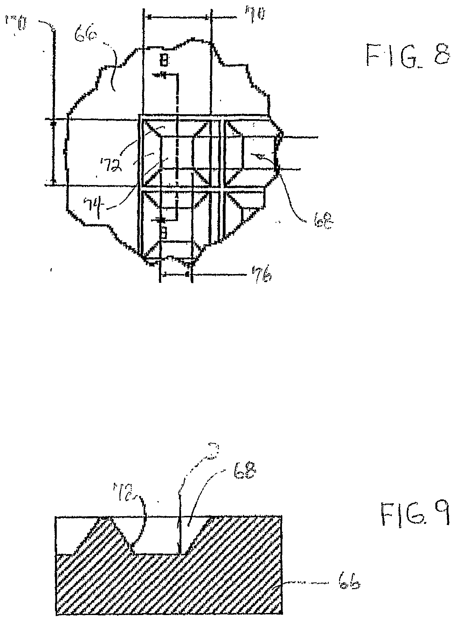

In Figs. 5-14, similar features share common reference numerals.

Figure 5 shows a portion of a high-density LED array 50 that may be used for applications requiring high optical power density at the working surface. In accordance with the present invention, these are curing applications in ink printing, the fabrication of DVDs and lithography. A high-density LED array is described in U.S. Patent Application No. 10/984,589, filed November 8, 2004. Array 50 includes a substrate 52 having micro-reflectors 54 formed therein. An LED 56 is mounted within each micro-reflector 54 in a manner known by those skilled in the art. Although the figures show only one LED associated with a micro-reflector each micro-reflector may be associated with one or more LEDs, such as one of each red, green, and blue or any combination thereof. One type of LED suitable for use is a P/N C395-XB290-E0400-X, manufactured by Cree, Inc., located in Durham, North Carolina, USA. Each LED 56 is bonded to substrate 52 using any known bonding technique such as a conductive adhesive, solder, or eutectic bond. Each LED 56 is electrically connected to a power source (not shown) through a lead line 58 connected in a known manner to a wire bond pad 60 on substrate 52. In this example, each row R(1), R(2), R(3) is electrically isolated by an isolation band 61. Each micro-reflector 54 includes a layer 62 of reflective and electrically conductive material both to reflect light from and to complete a circuit to electrically power an associated LED 56. Materials that are both optically reflective and electrically conductive and that can be bonded to electrically are limited to copper, aluminum, Au, and Ag, or combinations thereof. This construction provides micro-reflectors 54 that reflect light from an associated LED 56 and that are incorporated into the conductive circuitry to electrically power the associated LED 56.

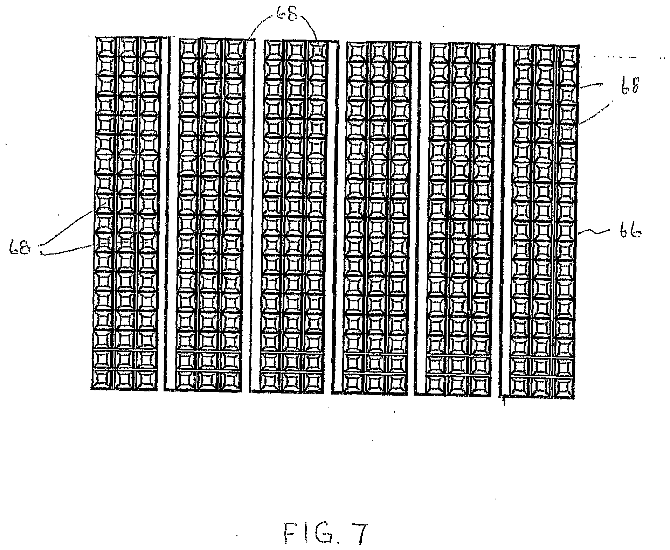

Substrate 52 is preferably a 1-0-0 crystalline silicon wafer having defined crystallographic axes that are determined by silicon's crystalline lattice. One of the consequences of silicon's crystalline nature is that etching of silicon can be made to progress preferentially along some crystallographic axes as compared to others. As a result, when the surface of a silicon wafer is properly oriented, masked to expose the surface to be etched, and placed in an etching solution such as potassium hydroxide or hydrofluorid acid, openings are etched in the silicon having walls with a characteristic slope of about 54.7 degrees. Substrate 52 is fabricated using a cleaned and polished 1-0-0 silicon wafer. The wafer surfaces are super cleaned to remove all contamination. Cleaning can include a hydrofluoric acid soak followed by one or more aluminum hydroxide soaks, multiple dump rinses, and a distilled water spin rinse dry in heated dry nitrogen. A silicon nitride layer is applied with vapor deposition or plasma enhanced vapor deposition. This layer can be, for example, about 240 nm (2,400 angstroms). The silicon nitride layer is then coated with photo resist on top that is imaged or exposed with a negative mask. It is necessary to remove photo resist from wafers prior to etching into the silicon. An oxygen plasma (12cc/min. oxygen flow at 360 watts) or positive resist stripper (such as Shipley 1112 A) followed by several distilled water rinses can be used here. The unexposed photo resist is removed to expose the surface where openings that will become the micro-reflectors are desired. In one example, the silicon surface is prepared to expose a plurality of square shapes having sides measuring about 700 micrometers (0.028 in.) and spaced apart in a center-to-center spacing of about 800 micrometers (0.032 in.). The exposed portions of the silicon nitride layer are then etched. The silicon nitride can be etched with buffered hydrofluoric acid (BHF), which will not attach silicon. An alternative to BHF is reactive ion etch (RIE). One example of the RIE for this application is to etch for 90 seconds at 150 watts and 50 standard cubic centimeters per minute Sulfur Hexafluoride (SF₆) at 100 mTorr vacuum. The silicon nitride openings are etched until the base silicon wafer is fully exposed and shiny. The potassium hydroxide (KOH) is a wet etch that attacks silicon preferentially in the 1-0-0 plane producing a characteristic anisotropic V-etch with sidewalls that form a 54.7 degree angle with the surface (35.3 degree from the normal). The etch rate can be about 75 nm (750 angstroms) per minute at room temperature using a potassium hydroxide (KOH) solution of 400 grams of KOH per liter of distilled water. At 52 degrees C the etch rate is about 14 micrometers per hour. The speed of the etch can be adjusted by those skilled in the art. The etch rate of the silicon nitride layer is about 300 times slower than the etch rate of the silicon. It may be necessary to monitor and adjust the thickness of the silicon nitride layer to insure it is properly masking during the entire base silicon wafer etching. Adding 1 percent isopropyl alcohol to the KOH solution will lower the surface tension of the solution and usually results in smoother etched walls. The result is a substrate 66 as seen in Figs. 7-9, having a densely packed array of openings 68. In this example, openings 68 are arranged in a densely packed array in a center-to-center spacing of about 800 micrometers (0.032 in.). Each micro-reflector is formed in a truncated pyramidal shape in which opening 68 has sides have dimensions 70 of about 700 micrometers (0.028 in.) square. Openings 68 have sidewalls 72 that slope to a base 74 at an angle of about 54.7 degrees from a horizontal plane. Base 74 has a dimension 76 of about 346 micrometers (0.014 in.) square and openings have a depth (D) of about 250 micrometers (0.010 in.). These dimensions are merely illustrative and the invention is not limited to the use of an LED array module having micro-reflectors with these dimensions. In accordance with the present invention, the openings are arranged so that the micro-reflectors have a center-to-center spacing of 3 mm or less.

Substrate 52 is then metallized to provide several thin film layers. Preferably, the film layers are applied using a vapor deposition process or a plasma enhanced vapor deposition process known by those skilled in the art. First, a dielectric coating of about 100 nm (1,000 angstroms) of silicon dioxide is applied to isolate the conductive circuit from the semiconductor. An adhesion layer of about 10-50 nm (100-500 angstroms) of titanium is then applied to improve adhesion of the metal layers. Next, a barrier metal layer of about 10-50 nm (100-500 angstroms) of nickel is applied to prevent metal migration between the layers. Finally, a light reflecting and electrically conducting layer is applied to form both an optical reflector and an electrical circuit. For UV light generation this layer can be about 1-10 micrometers of silver or aluminum, and for visible light the layer can be about 1-10 micrometers of gold. Another possible layer combination is to use 100 nm (1,000 angstroms) of silicon dioxide to isolate the conductive circuit followed by 100 nm (1,000 angstroms) of titanium to improve adhesion of the metal layers. A barrier layer of about 100 nm (1,000 angstroms) of nickel may be applied to prevent metal migration between the layers. The nickel layer may then by coated with about 6 micrometers of silver to form the reflective and electrical conductive layer. The nickel and silver material have the additional advantage of being an electrical conductor lending themselves to common bonding techniques used for semiconductor devices such as wire bonding with Au, Ag, Al, thermal adhesives and soldering processes. The heavy silver layer helps to carry high electrical currents to optimize optical UV power generation. It is not desirable to use heavy nickel layers due to the tendency of the nickel to cause peeling of the metal.

After the metallization process, isolation band 61 is formed using known processes to form the electrical circuits on the metallized substrate. There are several known methods of forming circuits on metallized substrates. For example, one method is to use a laser to cut through the metal and slightly into the silicon. Another method is to apply photo resist to the substrate, expose the substrate with a glass mask, etch with either wet etch or plasma, and rinse off the photo resist. The laser process has the advantage of being flexible and easy to change the location and geometry. The glass mask process has the advantage of using existing silicon fabrication systems. However, either process may be suitable. Metallization on the back of the silicon provides for solder attach a supporting structure such as a heat sink (not shown), for example. The metallization may be a heavy silver layer. This silver layer can be replaced by a flash of gold to protect the nickel. The flash of gold keeps the nickel from oxidizing for improved solderability. The gold will go into solution in the solder. Minimizing the gold thickness will minimize cost while insuring the solderability and will minimize gold embrittlement potential in the solder joint connection between the substrate and the supporting structure. Once the substrate has been fully processed the LEDs are mounted and bonded in a known manner discussed above to complete the LED array.

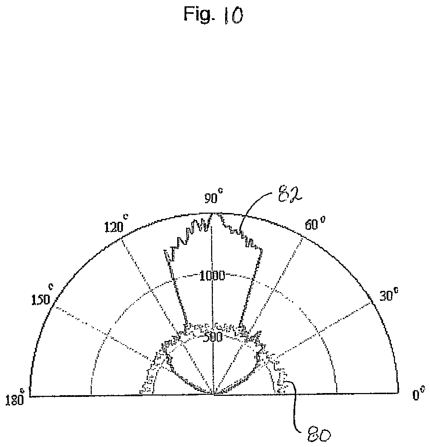

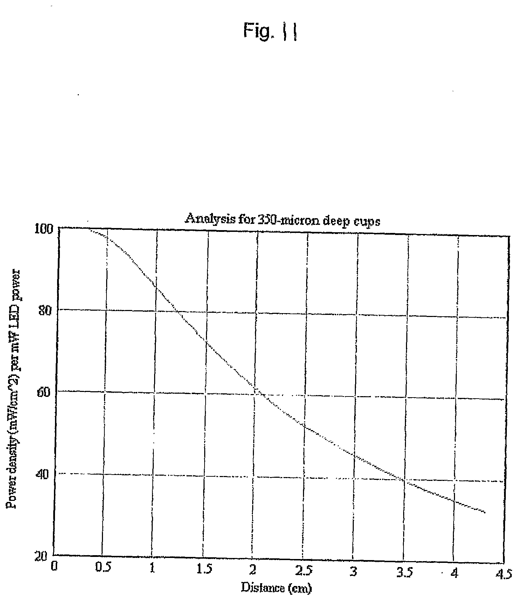

The LED array 50 provides an improved collection and collimation of light emitted from the LEDs. Figure 10 shows a graphic illustration of improved directionality in which curve 80 represents assumed angular irradiance distribution of an LED without the use of optics. Curve 82 represents the angular distribution of the same LED after mounting into a micro-reflector formed by anisotropic etching 350 microns deep in a silicon substrate. Figure 11 is a graphic illustration showing the calculated power as a function of distance for an array of LEDs mounted in the substrate arranged in a grid with a 1 mm center-to-center spacing. As seen by comparing the graphic illustrations of Fig. 2 and Fig. 7, the optical power density of LED arrays without reflectors drops by about 50% at a distance of only about 0.5 cm (Fig. 2). However, the optical power density of the LED array used for the curing applications of the present invention using the micro-reflectors drops by about 50% at a further distance of about 2.6 cm. Therefore, the LED array can be located further away from the work surface while maintaining a relatively high optical power density during use in the curing applications of the present invention.

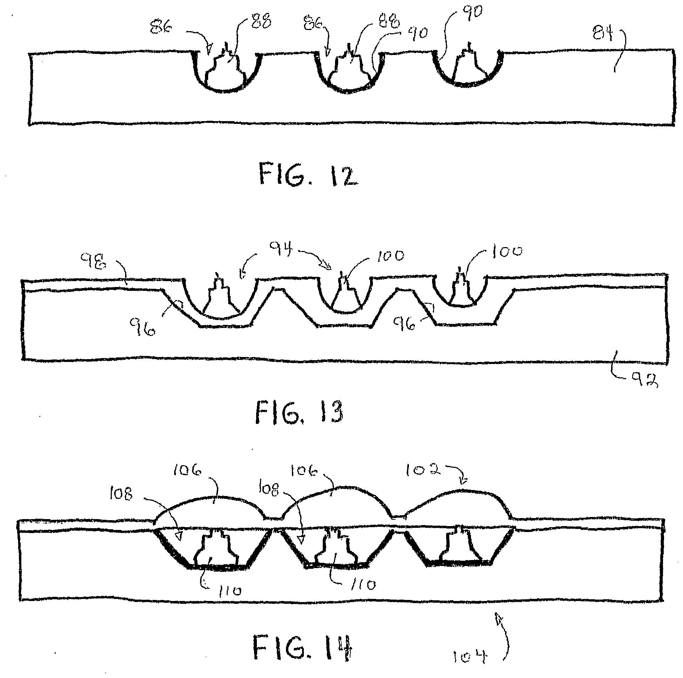

In accordance with the present invention, the etched micro-reflectors in Figs. 7-9 are shown as having an inverted truncated pyramidal shape. In other examples, not forming part of the present invention, other shapes may be used. For example, Fig. 12 shows a substrate 84 formed with an array of micro-reflectors 86 having a parabolic shape. An LED 88 is mounted in each micro-reflector as discussed above so that light from each LED 88 is reflective by layer 90. Layer 90 is both a reflective and electrically conductive layer as discussed above. Micro-reflectors 86 may be machined, stamped, cast, or hot forged into a silicon substrate or other thermally conductive material such as copper. Copper, copper tungsten, aluminum, or other metals can be used if a dielectric layer is added over the top of the pocketed base material prior to metallizing as described above for the silicon process. The base material can also be used as a return electrode if it is conductive. Alternatively, the base material can be a source electrode. Alternatively, parabolic micro-reflectors may be formed by a combination of etching and machining. For either process, machining may be achieved by known laser and plasma techniques.

In an alternative method of manufacturing an array module, a substrate material is first metallized. Electrical circuits are then structured on the metallized substrate and the substrate is then etched for form openings. The openings are then metallized to form micro-reflectors that both reflects light and electrically powers a semiconductor device. This has the advantage of allowing fine features to be formed in the electrical circuit separately from the etching and plating tasks associated with forming the openings.

Figure 13 shows another example, not forming part of the present invention, in which a plurality of micro-reflectors may be formed by a combination of etching and machining. Substrate 92 is formed with a plurality of micro-reflectors 94 wherein substrate 92 is first etched to form openings 96 in a manner discussed above with reference to Figs. 7-9. A layer of reflective and electrically conductive material 98 is applied to substrate 92 and micro-reflectors 94 having a parabolic shape are machined in each opening 96. A plurality of LEDs 100 are then mounted within the micro-reflectors 94 in the manner discussed above.

In the example as seen in Fig. 14, directionality of light can be further improved by molding or aligning a microlens array 102 over an LED array 104 similar to those of Figs. 7-9, 12, and 13. In this example, each microlens 106 is associated with a micro-reflector 108 to further collect and collimate light from an associated LED 110. One type of microlens array is shown and described in PCT Appl. No. PCT/US04/36370, filed November 1, 2004.

Persons skilled in the art will recognize that many modifications and variations are possible in the details, materials, and arrangements of the parts and actions which have been described and illustrated in order to explain the present invention and that such modifications and variations do not depart from the scope of the present invention as defined by the appending claims.

## Claims

1. Use of a light emitting diode array module (50) for curing applications in ink printing, DVD fabrication or lithography, the module comprising:
a substrate (52, 66) formed with a plurality of openings (68) that function as micro-reflectors (54), the micro-reflectors being arranged in an MxN array, M>1 and N>1, having a center-to-center spacing of 3 mm or less and each micro-reflector being formed in a truncated pyramidal shape; and
a plurality of light emitting diodes (56) mounted on the substrate, wherein each light emitting diode is mounted within each micro-reflector, and wherein light emitted from each light emitting diode is collected and collimated by the micro-reflector associated with the light emitting diode;
wherein each micro-reflector includes a layer of reflective and conductive material (62) to reflect light from its associated light emitting diode and to electrically power its associated light emitting diode.

2. Use of claim 1, wherein the module (50) further includes an array of micro-lenses (102), so that each micro-lens (106) is associated with a micro-reflector (54) to further collect and collimate light emitted from an associated light emitting diode (56).

3. Use of claim 1, wherein the reflective and conductive material (62) includes silver or aluminum, whereby selected wavelength(s) in the UV spectra are reflected.

4. Use of claim 1, wherein the reflective and conductive material (62) includes gold, whereby selected wavelength(s) in the visible spectra are reflected.

## Patentansprüche

1. Verwendung eines Leuchtdioden-Arraymoduls (50) für Aushärtungsanwendungen bei Tintendruck, DVD-Herstellung und Lithographie, wobei das Modul aufweist:
ein Substrat (52, 66), das mit einer Vielzahl von Öffnungen (68) gebildet ist, die als Mikroreflektoren (54) fungieren, wobei die Mikroreflektoren in einem M x N Array mit M > 1 und N > 1 mit einem Mittenabstand von 3 mm oder weniger angeordnet sind und jeder Mikroreflektor in Pyramidenstumpfform ausgebildet ist; und
eine Vielzahl von Leuchtdioden (56), die auf dem Substrat montiert sind, wobei
jede Leuchtdiode innerhalb jedes Mikroreflektors montiert ist, und wobei Licht, das von jeder Leuchtdiode emittiert wird, gesammelt und von dem Mikroreflektor, der der Leuchtdiode zugeordnet ist, kollimiert wird;
wobei jeder Mikroreflektor eine Schicht aus reflektiven und leitfähigen Material (62) aufweist, um Licht von dessen zugeordneter Leuchtdiode zu reflektieren und dessen zugeordnete Leuchtdiode elektrisch zu versorgen.

2. Verwendung nach Anspruch 1, wobei das Modul (50) ferner ein Array von Mikrolinsen (102) aufweist, so dass jede Mikrolinse (106) einem Mikroreflektor (54) zugeordnet ist, um ferner Licht, das von einer zugeordneten Leuchtdiode (56) emittiert wird, zu sammeln und zu kollimieren.

3. Verwendung nach Anspruch 1, wobei das reflektive und leitfähige Material (62) Silber oder Aluminium aufweist, wodurch ausgewählte Wellenlänge(n) in den UV-Spektren reflektiert werden.

4. Verwendung nach Anspruch 1, wobei das reflektive und leitfähige Material (62) Gold aufweist, wodurch ausgewählte Wellenlänge(n) in den sichtbaren Spektren reflektiert werden.

## Revendications

1. Utilisation d'un module réseau de diodes électroluminescentes (50) pour des applications de durcissement dans l'impression par jet d'encre, la fabrication de DVD ou lithographie, le module comprenant :
un substrat (52, 66) pourvu d'une pluralité d'ouvertures (68) qui fonctionnent comme des micro-réflecteurs (54), les micro-réflecteurs étant agencés dans un réseau MxN, M>1 et N>1, présentant un espacement centre à centre de 3 mm ou moins et chaque micro-réflecteur présentant une forme pyramidale tronquée ; et
une pluralité de diodes électroluminescentes (56) montées sur le substrat, dans laquelle chaque diode électroluminescente est montée à l'intérieur de chaque micro-réflecteur, et dans laquelle la lumière émise à partir de chaque diode électroluminescente est collectée et alignée par le micro-réflecteur associé à la diode électroluminescente ;
dans laquelle chaque micro-réflecteur comporte une couche de matériau réfléchissant et conducteur (62) pour la réflexion de lumière à partir de la diode électroluminescente qui lui est associée et l'alimentation en électricité de la diode électroluminescente qui lui est associée.

2. Utilisation selon la revendication 1, dans laquelle le module (50) comporte en outre un réseau de micro-lentilles (102), de sorte que chaque micro-lentille (106) est associée à un micro-réflecteur (54) pour collecter et aligner davantage la lumière émise à partir d'une diode électroluminescente associée (56).

3. Utilisation selon la revendication 1, dans laquelle le matériau réfléchissant et conducteur (62) comporte de l'argent ou de l'aluminium, moyennant quoi une ou plusieurs longueurs d'onde sélectionnées dans les spectres UV sont réfléchies.

4. Utilisation selon la revendication 1, dans laquelle le matériau réfléchissant et conducteur (62) comporte de l'or, moyennant quoi une ou plusieurs longueurs d'onde sélectionnées dans les spectres visibles sont réfléchies.
